# EUROPÄISCHE PATENTSCHRIFT

(11) **EP 2 891 192 B1**
(45) Veröffentlichungstag und Bekanntmachung des Hinweises auf die Patenterteilung: **24.03.2021**
(21) Anmeldenummer: 13745673.7
(22) Anmeldetag: 07.08.2013
(51) Int. Cl.: H01L 33/54, H01L 25/075, H01L 33/56

(54) **VERFAHREN ZUM HERSTELLEN EINES LED-MODULS UND LED-MODUL**
METHOD OF MANUFACTURING AN LED MODULE AND LED MODULE
PROCEDE POUR FABRIQUER UN MODULE DEL ET MODULE DEL

(30) Priorität: 31.08.2012 DE 102012215514
(43) Veröffentlichungstag der Anmeldung: 08.07.2015
(73) Patentinhaber: OSRAM GmbH, 80807 München (DE)
(72) Erfinder: REISS, Martin, 93161 Sinzing (DE); SCHWALENBERG, Simon, 93093 Donaustauf (DE)
(74) Vertreter: OSRAM GmbH - GC IP
(86) Internationale Anmeldenummer: PCT/EP2013/066534
(87) Internationale Veröffentlichungsnummer: WO 2014/032924

(56) Entgegenhaltungen:
- WO-A2-2007/137006
- DE-A1- 2 851 951
- DE-A1- 10 229 067
- DE-A1-102007 015 474
- US-A1- 2005 221 519
- US-A1- 2009 152 582
- US-A1- 2010 277 932
- US-A1- 2011 069 256

## Beschreibung

### Technisches Gebiet

Die Erfindung betrifft ein Verfahren zum Herstellen eines LED-Moduls und ein nach diesem Verfahren hergestelltes LED-Modul.

### Stand der Technik

Aus dem Stand der Technik sind lineare LED-Module bekannt, bei denen LEDs linear in Reihe in einem Gehäuse mit einer Lichtaustrittseite angeordnet sind. Um nun die LEDs möglichst nicht mehr als einzelne Lichtquellen wahrnehmen zu können und eine möglichst hohe Homogenität des abgestrahlten Lichts in Bezug auf die Helligkeit und die Lichtfarbe zu bewerkstelligen, kann in das Gehäuse ein lichtstreuendes Matrixmaterial eingebracht werden, durch dessen Lichtmisch- und Streueffekt eine homogenere Abstrahlung des Lichts ermöglicht wird. Um eine zufriedenstellende Lichtmischung der einzelnen LEDs zu erreichen, muss die Dicke des Matrixmaterials, d.h. der Abstand von einer Lichtaustrittsfläche der LED bis zur Lichtaustrittsseite des LED-Moduls entsprechen groß sein, insbesondere muss diese Dicke um so größer sein, je größer der Abstand der LEDs voneinander ist. Nachteilig dabei ist, dass es bei einer Verwendung eines Volumenstreuers, wie dem streuenden Matrixmaterial, zur Homogenisierung des Lichts zu großen Lichtverlusten kommt, was die Lichtauskopplungseffizienz mindert. Dieser Effekt ist um so größer, je dicker das streuende Matrixmaterial ist. Um die Lichtverluste durch das dicke streuende Matrixmaterial zu reduzieren, kann man als Matrixmaterial zunächst eine transparente Schicht vorsehen, auf deren Oberfläche eine dünnere Streuschicht aufgebracht wird. Es sind dann zwar weniger Lichtverluste durch die Streuschicht zu verzeichnen, jedoch treten bei dieser Ausgestaltung andere Probleme auf. Insbesondere gibt es durch diese zwei- oder mehrschichtige Struktur Phasengrenzen zwischen den Schichten, unter anderem bedingt durch zwischen den Schichten befindliche Klebeschichten zur Fixierung der einzelnen Schichten aneinander, an denen das Licht reflektiert wird.

Weiterhin sind die Herstellungsverfahren für solche LED-Module sehr aufwendig und teuer, da zum Aufbringen der einzelnen Schichten aufeinander aufwendige Oberflächenvorbehandlungen, wie beispielsweise gezielte Plasma-Oberflächenvorbehandlungen, erforderlich sind, um eine ausreichende Haftung der Streuschicht auf der transparenten Schicht zu erzielen. Insbesondere muss durch produktionstechnisch sehr aufwendige Verfahren sichergestellt werden, dass sich keine Delaminationen zwischen den Schichten bilden, welche zusätzliche Grenzschichten im Strahlengang der LED zur Folge haben, die sich in einem linearen Produkt sehr leicht als deutlich wahrnehmbare lokale Lichtfarbenunterschiede zu erkennen geben.

Dennoch treten im Laufe der Zeit durch Beanspruchungen, wie eine unterschiedliche thermische Ausdehnung der Schichten, lokale Delaminationen zwischen den Schichten auf, die wiederum zu einer erhöhten Reflexion des Lichts führen und Farbschwankungen entlang des linearen Moduls verursachen. Somit kann auch durch diese mehrschichtige Anordnung bislang keine zufriedenstellende Auskopplungseffizienz und Homogenität des abgestrahlten Lichts erreicht werden.

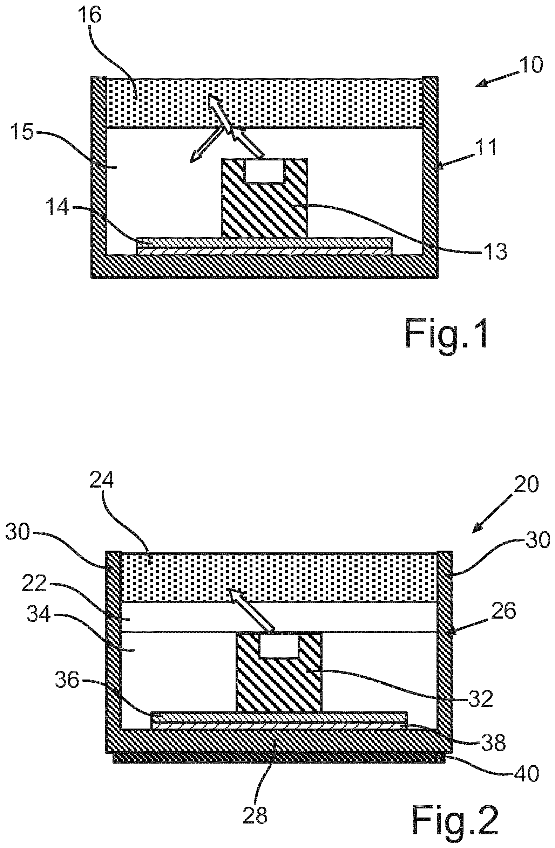

Fig. 1 zeigt schematisch ein mehrschichtiges LED-Modul 10 gemäß dem Stand der Technik im Querschnitt zur Veranschaulichung dieser Problematik. Das LED-Modul 10 umfasst dabei ein Gehäuse 11, insbesondere als U-Profil ausgebildet, und eine an einer Grundseite 12 des Gehäuses 11 angeordnete LED 13 auf einer Leiterplatte 14. Weiterhin ist in das Gehäuse 11 ein transparentes Matrixmaterial 15 eingebracht, auf dem eine Streuschicht 16 angeordnet ist. Die eingezeichneten Pfeile sollen dabei schematisch das von der LED 13 abgestrahlte Licht darstellen. Nachteilig bei diesem LED-Modul 10 ist, dass durch Phasengrenzen zwischen den Schichten 15 und 16 eine starke Reflexion des von der LED 13 abgestrahlten Lichts auftritt. Diese Phasengrenzen sind unter anderem durch unterschiedliche Brecheigenschaften der transparenten Schicht 15 und der Streuschicht 16, sowie durch dazwischen befindliche Klebeschichten bedingt. Durch Beanspruchung des LED-Moduls 10 kommen weiterhin lokale Delaminationen dazu, die diesen Effekt der starken Reflexion noch verstärken und zudem auch Farbschwankungen entlang des LED-Moduls 10 verursachen.

Das Dokument DE 102007015474 A1 beschreibt ein optoelektronisches Bauelement und ein Verfahren zur Herstellung des optoelektronischen Bauelements. Das Verfahren beinhaltet eine mehrschichtige Kapselung des optoelektronischen Bauelements.

Das Dokument WO 2007137006 A2 beschreibt ein Verfahren zur Herstellung einer LED-Leuchtvorrichtung. Das Verfahren beinhaltet eine mehrschichtige Kapselung einer LED.

Das Dokument US 20090152582 A1 beschreibt eine LED mit einer mehrschichtigen Kapselung des LED-Chips. Die erste Lichtstreuungsschicht, die den LED-Chip bedeckt, weist eine an der dem LED-Chip gegenüberliegenden Seite konkave Oberfläche auf.

Das Dokument US 20100277932 A1 beschreibt ein LED-Gehäuse. An der Innenseite des Gehäuses sind eine Einkerbung und/oder ein Vorsprung angeordnet.

Das Dokument US2005221519 A1 beschreibt ein Verfahren zur Herstellung eines LED-Moduls umfassend drei Verkapselungsschichten. Insbesondere wird die unterste Schicht nur bis unterhalb der LED-Oberkante eingefüllt und dann ausgehärtet, bevor die nachfolgende Schicht eingefüllt wird.

### Darstellung der Erfindung

Die Aufgabe der vorliegenden Erfindung ist es, ein LED-Modul und ein Verfahren zum Herstellen eines LED-Moduls bereitzustellen, mittels welchen sich eine hohe Homogenität des vom LED-Modul abgestrahlten Lichts bereitstellen lässt ohne Einbußen bei der Auskopplungseffizienz in Kauf nehmen zu müssen.

Diese Aufgabe wird gelöst durch ein Verfahren zum Herstellen eines LED-Moduls sowie einem LED-Modul gemäß den Merkmalen der unabhängigen Ansprüche.

Vorteilhafte Ausgestaltungen finden sich in den abhängigen Ansprüchen.

Beim erfindungsgemäßen Verfahren zum Herstellen eines LED-Moduls wird zunächst ein Gehäuse bereitgestellt, das als Hohlkörper ausgebildet ist, welcher eine Öffnung an einer Lichtaustrittsseite des LED-Moduls aufweist. Weiterhin weist das Gehäuse eine Grundseite auf, die der Lichtaustrittsseite gegenüberliegend angeordnet ist. Des Weiteren wird eine Leiterplatte mit mindestens einer LED auf der Grundseite des Gehäuses angeordnet. Es wird mindestens eine erste Grundschicht aus einem aushärtbaren Material in einem nicht ausgehärteten Zustand durch die Öffnung in das Gehäuse eingefüllt und weiterhin wird eine Streuschicht aus einem ebenfalls aushärtbaren Material in einem nicht ausgehärteten Zustand durch die Öffnung in das Gehäuse eingefüllt.

Gemäß einem ersten Aspekt der Erfindung wird die Streuschicht auf die erste Grundschicht eingefüllt, wobei die erste Grundschicht beim Einfüllen der Streuschicht nicht ausgehärtet ist, und nach Einfüllen der Streuschicht die mindestens eine erste Grundschicht und die Streuschicht ausgehärtet werden.

Die erste Grundschicht soll dabei aus einem transparenten Material sein. Durch diese transparente Schicht kann der Abstand der Streuschicht zur LED wohldefiniert eingestellt werden. Insbesondere kann die Schichtdicke und somit der Abstand der LED zur Streuschicht angepasst auf die Abstände gegebenenfalls mehrerer linear angeordneter LEDs des LED-Moduls eingestellt werden, so dass sich eine besonders hohe Homogenität der Helligkeit des abgestrahlten Lichts des LED-Moduls, besonders entlang des LED-Moduls, d.h. entlang der linearen Anordnung der LEDs, bewerkstelligen lässt. Durch das Einfüllen der Streuschicht auf die noch nicht ausgehärtete Grundschicht wird eine besonders gute Haftung der Streuschicht auf der Grundschicht bewerkstelligt. Die Gefahr für im Laufe der Zeit auftretende Delaminationen ist somit gering, wodurch mittels des Verfahrens die Auskopplungseffizienz und auch die Homogenität des abgestrahlten Lichts bezüglich der Lichtfarbe auf besonders vorteilhafte Weise erhöht werden kann. Ein weiterer Vorteil ist, dass durch dieses Verfahren keine Klebeschicht zwischen der Streuschicht und der Grundschicht erforderlich ist. Durch Klebeschichten bedingte Phasengrenzen können so vermieden werden, wodurch auch die Reflexionen an Grenzschichten zwischen den Schichten reduziert und somit ebenfalls die Auskopplungseffizienz erhöht werden kann. Darüber hinaus erfordert dieses Verfahren keine aufwendigen und kostspieligen Oberflächenbehandlungen der Grundschicht, um für ausreichend Haftung der Schichten aneinander zu sorgen. Damit ist dieses Verfahren zur Herstellung eines LED-Moduls auch wesentlich einfacher und kostengünstiger.

Gemäß einem zweiten Aspekt der Erfindung wird beim Einfüllen der ersten Grundschicht derart viel aushärtbares Material eingefüllt, dass eine Oberfläche der eingefüllten Grundschicht eine durch eine Füllmenge vorgebbare Krümmung annimmt.

Beispielsweise kann die Grundschicht nahezu bis an den oberen Rand des Gehäuses eingefüllt werden. Dieser obere Rand ist dabei als eine Oberkante einer Begrenzungsseite des Gehäuses definiert, wobei die Begrenzungsseite die Seitenflächen des Gehäuses bildet. Insbesondere ist diese Begrenzungsseite an der Grundseite des Gehäuses angeordnet und erstreckt sich von der Grundseite bis zur Lichtaustrittsseite des LED-Moduls, wobei die Grundseite und die Begrenzungsseite den Hohlkörper mit der Öffnung definieren, als welcher das Gehäuse ausgebildet ist. Erreicht die Füllmenge also diesen oberen Rand des Gehäuses, so bildet sich eine nach außen gewölbte, konvexe Form der Oberfläche der ersten Grundschicht aus. Die daraufhin auf die erste Grundschicht eingefüllte Streuschicht ist somit ebenfalls gekrümmt bzw. nach außen gewölbt. Insbesondere kann so eine konkav-konvexe Form der Streuschicht erreicht werden. Das Material der ersten Grundschicht kann aber auch in einer geringeren Menge in das Gehäuse eingefüllt werden, insbesondere nur bis zu einer bestimmten Höhe. Bei einer geeigneten Benetzung der ersten Grundschicht zur Begrenzungsseite des Gehäuses bildet sich eine nach unten gewölbte, insbesondere konkave, Oberfläche der ersten Grundschicht aus. Beim anschließenden Einfüllen der Streuschicht auf die erste Grundschicht kann so beispielsweise eine bi-konvexe Form der Streuschicht gebildet werden.

So kann durch die Füllmenge der ersten Grundschicht zum einen eine vorgebbare Krümmung deren Oberfläche erreicht werden und demzufolge auch eine entsprechende Formgebung der daraufhin eingefüllten Streuschicht. Diese Krümmung der Oberfläche hat ebenfalls Auswirkungen auf die Homogenität des abgestrahlten Lichts, insbesondere kann so auf besonders vorteilhafte Weise eine hohe Homogenität in einer Richtung senkrecht zur Längserstreckungsrichtung des LED-Moduls erreicht werden. Längserstreckungsrichtung ist dabei so zu verstehen, dass bei einer Anordnung mehrerer LEDs an der Grundseite des Gehäuses in linearer Weise bzw. im Wesentlichen in einer Linie, die Richtung dieser linearen Anordnung als Längserstreckungsrichtung definiert ist. Auch bei einer Anordnung nur einer LED im Gehäuse kann so eine besonders hohe Homogenität des abgestrahlten Lichts erreicht werden, insbesondere in einer Richtung von einer zentralen Abstrahlachse der LED nach außen hin, d.h. bei einer möglichst mittigen Anordnung der LED auf der Grundseite des Gehäuses, zur Begrenzungsseite des Gehäuses hin. Auch hierbei können durch geeignete Ausbildung der Krümmung der Oberfläche der ersten Grundschicht Reflexionen reduziert werden. Beispielsweise trifft von der LED abgestrahltes Licht auf eine nach außen gewölbte Oberfläche der ersten Grundschicht überall nahezu senkrecht auf, wodurch die Auskopplungseffizienz ebenfalls erhöht werden kann.

Besonders bevorzug ist eine Ausgestaltung des erfindungsgemäßen Verfahrens, das die beiden erfindungsgemäßen Aspekte des Verfahrens umfasst. Dadurch lässt sich eine Steigerung in der Homogenität des abgestrahlten Lichts des LED-Moduls in jeder Richtung bezüglich Helligkeit und Lichtfarbe erzielen, die Auskopplungseffizienz erhöhen und gleichzeitig auch die Kosten und den Aufwand des Herstellungsverfahrens reduzieren.

Bei einer vorteilhaften Ausgestaltung der Erfindung wird beim Bereitstellen des Gehäuses in eine Begrenzungsseite des Gehäuses zumindest bereichsweise eine Einkerbung eingebracht, die in einem Abstand zur Grundseite des Gehäuses verläuft. Dabei ist die Begrenzungsseite an der Grundseite angeordnet und erstreckt sich von der Grundseite bis zur Lichtaustrittsseite des LED-Moduls, wobei die Grundseite und die Begrenzungsseite den Hohlkörper mit der Öffnung definieren.

Durch diese Einkerbung kann auf besonders vorteilhafte Weise die Höhe der Benetzung der ersten Grundschicht zur Begrenzungsseite des Gehäuses eingestellt werden. Beim Einfüllen der ersten Grundschicht wird die Begrenzungsseite von der ersten Grundschicht dabei maximal nur bis zur Einkerbung benetzt. Weiterhin bildet sich, wie bereits erwähnt, eine, insbesondere konkav, gekrümmte Oberfläche der ersten Grundschicht aus. Dadurch dass die Höhe der Benetzung zur Begrenzungsseite durch die Einkerbung vorgegeben ist, kann durch die Einfüllmenge des Materials der ersten Grundschicht ebenfalls die Krümmung der Oberfläche bestimmt werden. Dabei wird bevorzugt soviel Material in das Gehäuse eingefüllt, dass sich die Oberfläche der ersten Grundschicht unterhalb der Einkerbung befindet, wobei die Begrenzungsseite bis zur Einkerbung benetzt wird. Je mehr Material eingefüllt wird, desto weniger stark ist die Oberfläche gekrümmt. So kann auf besonders vorteilhafte Weise auch der Krümmungsradius der gekrümmten Oberfläche der ersten Grundschicht durch die Füllmenge des Materials eingestellt werden. Dadurch kann eine Homogenisierung des abgestrahlten Lichts erreicht werden, die auf die Geometrie des LED-Moduls, also beispielsweise Höhe, Breite, Anordnung der LED, Abstrahlwinkel der LED, usw., optimal angepasst ist.

Bei einer besonders bevorzugten Ausgestaltung der Erfindung wird für die Streuschicht ein Material verwendet, das ein Basismaterial mit Streupartikeln umfasst, wobei das Basismaterial dieselben Eigenschaften besitzt wie das der ersten Grundschicht, so dass sich beim Aushärten der ersten Grundschicht und der Streuschicht keine Phasengrenze bildet.

Insbesondere soll dabei das Basismaterial der Streuschicht dasselbe Material wie das der ersten Grundschicht sein, wobei dieses Basismaterial der Streuschicht zusätzlich mit Streupartikeln versehen ist. Dadurch besitzen die erste Grundschicht und die Streuschicht dieselben Materialeigenschaften, wie beispielsweise denselben Brechungsindex, denselben Wärmeausdehnungskoeffizienten, usw.. Die Wahl desselben Materials bzw. Basismaterials hat eine Vielzahl von Vorteilen. Zum einen können durch den selben Brechungsindex wiederum Reflexionen an der Streuschicht reduziert werden und zum anderen können auch mechanische Beanspruchungen, wie beispielsweise durch Wärmeausdehnung, durch den selben Wärmeausdehnungskoeffizienten vermieden werden. Dies verhindert wiederum das Entstehen von Delaminationen was wiederum weniger Verluste durch Reflexionen zur Folge hat, die Auskopplungseffizienz erhöht und die Homogenität des abgestrahlten Lichts steigert. Besonders vorteilhaft ist diese Ausgestaltung in Kombination mit einem Verfahren gemäß dem ersten Aspekt der Erfindung. Indem die Streuschicht auf die noch nicht ausgehärtete erste Grundschicht eingefüllt wird, und diese Schichten gleichzeitig ausgehärtet werden, verschmelzen diese Schichten gewissermaßen miteinander. Dadurch, dass diese Schichten auch noch aus dem selben Material bzw. Basismaterial sind, entsteht keine Phasengrenze zwischen den Schichten. Die erste Grundschicht und die Streuschicht bilden sozusagen eine Einheit bzw. eine einheitliche Schicht, wobei sich in einem definierten Bereich dieser einheitlichen Schicht Streupartikel befinden. Dieser Bereich mit den Streupartikel kann als Streuschicht definiert werden. Es gibt also keinerlei Fresnel-Rückreflexe des von der LED abgestrahlten Lichts, welche auf den Komponentenoberflächen, wie beispielsweise der Leiterplatte, absorbiert werden, wodurch die Auskopplungseffizienz optimiert werden kann. Es tritt auch keine totale interne Reflexion auf, welche das farblich gelblichere Licht weißer LEDs in hohen Abstrahlwinkeln zurückreflektiert und so zu einem Blau-Farbschift des LED-Moduls führen würde.

Bei einer weiteren bevorzugten Ausgestaltung der Erfindung weist die LED eine Lichtaustrittsseite auf, die eine Oberkante der LED definiert. Die mindestens eine erste Grundschicht wird derart eingefüllt, dass eine nach dem Einfüllen der Grundseite des Gehäuses gegenüberliegende Oberfläche der ersten Grundschicht einen Abstand zur Lichtaustrittseite des LED-Moduls aufweist der kleiner ist als ein Abstand der Oberkante der LED von der Lichtaustrittsseite des LED-Moduls.

So kann durch das Einfüllen der ersten Grundschicht bis zu einer bestimmten Höhe der Abstand der Streuschicht zur LED wohldefiniert eingestellt werden. Insbesondere kann die Schichtdicke der ersten Grundschicht und somit der Abstand der LED zur Streuschicht angepasst auf die Abstände mehrerer linear angeordneter LEDs des LED-Moduls eingestellt werden. Bevorzugt ist bei einem größeren Abstand von mehreren linear angeordneten LEDs die Schichtdicke der ersten Grundschicht entsprechend größer zu wählen. Dadurch lässt sich eine besonders hohe Homogenität der Helligkeit des abgestrahlten Lichts des LED-Moduls, besonders entlang des LED-Moduls, d.h. entlang der linearen Anordnung der LEDs, bewerkstelligen.

Erfindungsgemäß wird vor dem Einfüllen der ersten Grundschicht eine zweite Grundschicht durch die Öffnung des Gehäuses in das Gehäuse eingefüllt, wobei auf die zweite Grundschicht die erste Grundschicht eingefüllt wird.

Diese zweite Grundschicht weist dabei eine weiße Pigmentierung auf. Durch diese zusätzliche Schicht kann beispielsweise das Erscheinungsbild des LED-Moduls und seines Abstrahlverhalten nach bestimmten Ansprüchen oder optischen Erfordernissen gestaltet werden. Insbesondere gewährleistet die weiße Pigmentierung eine gute Reflektivität von zurückreflektiertem Licht, wodurch auch dadurch die Auskopplungseffizienz zusätzlich gesteigert werden kann.

Die zweite Grundschicht wird dabei erfindungsgemäß höchstens bis zur Oberkante der LED eingefüllt. Nach dem Aushärten dieser Schicht wird dann die erste Grundschicht eingefüllt und zusammen mit der anschließend eingefüllten Streuschicht ausgehärtet

Das erfindungsgemäße LED-Modul umfasst ein Gehäuse, das als Hohlkörper ausgebildet ist, der eine Öffnung an einer Lichtaustrittsseite des LED-Moduls aufweist. Das Gehäuse weist eine Grundseite auf, die der Lichtaustrittsseite gegenüberliegend angeordnet ist, und einer Begrenzungsseite, die an der Grundseite angeordnet ist und sich von der Grundseite bis zur Lichtaustrittsseite des LED-Moduls erstreckt. Die Grundseite und die Begrenzungsseite definieren dabei den Hohlkörper mit der Öffnung. Das LED-Modul umfasst weiterhin eine Leiterplatte, die auf der Grundseite des Gehäuses angeordnet ist, und eine LED, die auf der Leiterplatte angeordnet ist, und die eine Lichtaustrittsseite aufweist, die eine Oberkante der LED definiert. Des Weiteren umfasst das LED-Modul eine im Gehäuse angeordnete Schichtenfolge mit Schichten in einer Abfolge in einer Richtung von der Grundseite des Gehäuses zur Lichtaustrittsseite des LED-Moduls. Die Schichtenfolge ist dabei die LED einschließend und die Begrenzungsfläche des Gehäuses kontaktierend angeordnet und weist mindestens eine erste Grundschicht und eine Streuschicht auf, wobei die erste Grundschicht und die Streuschicht jeweils aus einem Material gebildet sind, und die Streuschicht einen Abstand zur LED aufweist. Die Streuschicht ist auf der ersten Grundschicht angeordnet, wobei die erste Grundschicht zumindest zwischen der Streuschicht und der Oberkante der LED angeordnet ist.

Bei einem LED-Modul gemäß einem dritten Aspekt der Erfindung umfasst das Material der Streuschicht ein Basismaterial mit Streupartikeln, wobei das Basismaterial dasselbe Material ist, wie das der ersten Grundschicht.

Dadurch besitzen die erste Grundschicht und die Streuschicht dieselben Materialeigenschaften, wie beispielsweise denselben Brechungsindex, denselben Wärmeausdehnungskoeffizienten, usw.. Die Wahl desselben Materials bzw. Basismaterials hat auch hier die bereits oben beschriebenen Vorteile, dass zum einen durch den selben Brechungsindex Reflexionen an der Streuschicht reduziert werden und zum anderen können auch mechanische Beanspruchungen, wie beispielsweise durch Wärmeausdehnung, durch den selben Wärmeausdehnungskoeffizienten vermieden werden. Dies verhindert wiederum das Entstehen von Delaminationen was wiederum weniger Verluste durch Reflexionen zur Folge hat, die Auskopplungseffizienz erhöht und die Homogenität des abgestrahlten Lichts steigert. So können auf besonders vorteilhafte Weise die im Stand der Technik auftretenden Probleme, die aus Materialinkompatibilitäten resultieren, beseitigt werden. Als Material eignet sich dabei besonders ein Polymermaterial, wie beispielsweise Silikon oder Polyurethan. Die Streuschicht weist dabei noch Streupartikel auf, die bevorzugt an den LED-Typ angepasst sind.

Bei einem LED-Modul gemäß einem vierten Aspekt der Erfindung weist die Streuschicht eine Dicke auf, die räumlich nicht konstant ist.

So kann bewerkstelligt werden, dass der Weg, den das von der LED abgestrahlte Licht durch die Streuschicht zurücklegt, in alle Abstrahlrichtungen gleich ist. So ist auch der Lichtmisch- und Streueffekt der Streuschicht auf das von der LED abgestrahlte Licht in alle Abstrahlrichtungen derselbe, wodurch eine besonders hohe Homogenität des durch das LED-Modul abgestrahlten Lichts erreicht werden kann.

Eine besonders bevorzugte Ausgestaltung der Erfindung umfasst die beiden erfindungsgemäßen Aspekte des LED-Moduls mit den eben beschriebenen Vorteilen.

Weiterhin ist es bevorzugt, dass die Dicke der Streuschicht in einem Bereich mit einem kleineren Abstand zur Begrenzungsseite des Gehäuses kleiner ist als die Dicke der Streuschicht in einem Bereich mit einem größeren Abstand zur Begrenzungsfläche des Gehäuses. Bei einer linearen Anordnung mehrerer LEDs in einer Längserstreckungsrichtung des Gehäuses ist der Abstand zur Begrenzungsseite in der Querschnittsebene senkrecht zur Längserstreckungsrichtung des Gehäuses zu verstehen. Dadurch kann bewerkstelligt werden, dass der Weg, den das von der LED abgestrahlte Licht durch die Streuschicht zurücklegt, in alle Abstrahlrichtungen gleich ist, falls die LED in einem zentralen Bereich der Grundseite des Gehäuses bezüglich der Begrenzungsseite des Gehäuses angeordnet ist, insbesondere wieder zu verstehen in einem Querschnitt senkrecht zu einer Längserstreckungsrichtung des Gehäuses. Wie oben beschrieben, führt dies zu einer besonders hohen Homogenität des vom LED-Modul abgestrahlten Lichts.

Bei einer vorteilhaften Ausgestaltung der Erfindung weisen die mindestens eine erste Grundschicht und die Streuschicht eine gemeinsame Zwischenfläche auf, die eine Krümmung aufweist. Des Weiteren ist die Krümmung durch eine Menge an Material der ersten Grundschicht und/oder eine Ausgestaltung der Begrenzungsfläche des Gehäuses vorgebbar. Beispielsweise kann die Begrenzungsfläche eine Einkerbung aufweisen. Durch diese Einkerbung kann zusammen mit der Füllmenge des Materials der ersten Grundschicht die Krümmung der Oberfläche der Grundschicht, also der Zwischenfläche zwischen der ersten Grundschicht und der Streuschicht, wie oben bereits beschrieben, vorgegeben werden. Die genannte Zwischenfläche kann dabei auch als virtuelle Zwischenfläche verstanden werden, insbesondere bei einem LED-Modul, das mittels des Verfahrens gemäß dem ersten Aspekt der Erfindung hergestellt ist, da die erste Grundschicht und die mit dieser sozusagen verschmolzenen Streuschicht eher als zwei Bereiche einer einzigen Schicht anzusehen sind, wobei einer dieser Bereiche Streupartikel aufweist.

Weiterhin kann die Zwischenfläche konkav oder konvex sein. Darüber hinaus ist es vorteilhaft, wenn auch die Streuschicht an der Lichtaustrittseite des LED-Moduls eine Oberfläche aufweist, die eine Krümmung aufweist. So lassen sich Formen der Streuschicht, wie eine bi-konvexe Form oder eine konkav-konvexe Form umsetzen, die die vorteilhafte Eigenschaft aufweisen, dass die Streuschicht in der Mitte, also in einem Bereich mit einem größeren Abstand zur Begrenzungsseite des Gehäuses, dicker ist als am Rand, also in einem Bereich mit einem kleineren Abstand zur Begrenzungsseite des Gehäuses.

Des Weiteren gelten die für die erfindungsgemäßen Verfahren genannten Vorteile, Merkmale und Ausgestaltungsvarianten in gleicher Weise, soweit anwendbar, für das erfindungsgemäße LED-Modul und seine Ausgestalungsvarianten. Insbesondere lassen sich die genannte Ausgestaltungsvarianten und einzelnen Merkmale beliebig miteinander kombinieren.

Weitere Vorteile, Merkmale und Einzelheiten der Erfindung ergeben sich aus den Ansprüchen, der nachfolgenden Beschreibung bevorzugter Ausführungsformen sowie anhand der Zeichnung.

### Kurze Beschreibung der Zeichnungen

Im Folgenden soll die Erfindung anhand von Ausführungsbeispielen näher erläutert werden. Die Figuren zeigen:
- Fig. 1: eine schematische Darstellung eines mehrschichtigen LED-Moduls gemäß dem Stand der Technik;
- Fig. 2: eine schematische Darstellung eines LED-Moduls mit einer transparenten Grundschicht und einer Streuschicht gemäß einem Ausführungsbeispiel der Erfindung;
- Fig. 3: eine schematische Darstellung eines LED-Moduls mit einer transparenten Grundschicht und einer Streuschicht mit einer bi-konvexen Form gemäß einem Ausführungsbeispiel der Erfindung;
- Fig. 4: eine schematische Darstellung eines LED-Moduls mit einer transparenten Grundschicht und einer Streuschicht mit einer konkav-konvexen Form gemäß einem Ausführungsbeispiel der Erfindung; und
- Fig. 5: eine schematische Darstellung des Lichtwegs einer LED eines LED-Moduls mit einer transparenten Grundschicht und einer Streuschicht mit einer konkav-konvexen Form gemäß einem Ausführungsbeispiel der Erfindung.

### Bevorzugte Ausführung der Erfindung

Fig. 2 zeigt eine schematische Darstellung eines LED-Moduls 20 mit einer ersten transparent ausgebildeten Grundschicht 22 und einer Streuschicht 24 gemäß einem Ausführungsbeispiel der Erfindung. Das LED-Modul 20 umfasst dabei ein Gehäuse 26 mit einer Grundseite 28 und einer Begrenzungsseite 30, welche das LED-Modul 20 nach außen hin begrenzt. Die Begrenzungsseite 30 kann dabei mehrere Bereiche umfassen, wie beispielsweise einen vorderen Bereich, einen hinteren Bereich, und zwei seitliche Bereiche, je nach Ausbildung des Gehäuses 26. Das Gehäuse 26 kann beispielsweise auch rund ausgebildet sein, rotationssymmetrisch oder rinnenförmig. Bevorzugt ist dabei eine Ausbildung des Gehäuses 26, das, wie dargestellt, in einem Querschnitt ein U-Profil aufweist und sich in einer Längserstreckungsrichtung senkrecht zur dargestellten Querschnittsebene erstreckt. In dieser Längserstreckungsrichtung können mehrere LEDs 32 linear angeordnet sein, insbesondere auf einer Leiterplatte 36, die auf der Grundseite 28 des Gehäuses 26 angeordnet ist. Das LED-Modul 20 weist weiterhin eine erste Grundschicht 22 auf, die aus einem transparenten Matrixmaterial gebildet ist. Auf dieser ersten Grundschicht 22 ist eine Streuschicht 24 angeordnet, die bevorzugt aus demselben Matrixmaterial mit Streupartikeln gebildet ist. Das LED-Modul 20 weist noch eine zweite Grundschicht 34 auf, die als weiß pigmentierte Schicht ausgebildet ist und bis zur LED-Oberkante reicht.

Auf der Grundseite 28 des Gehäuses 26 kann der LED-Streifen, also die auf einer beispielsweise flexiblen Leiterplatte 36 angeordneten LEDs 32, mittels eines Polymer-Klebers 38 dauerhaft fixiert werden. Das Gehäuse 26 kann dabei aus einem Polymerwerkstoff, wie Silikon, Polyurethan, Polycarbonat, oder Metall, wie Aluminium, Edelstahl, usw., gefertigt sein. Für den LED-Streifen kann dabei ein Substrat, wie beispielsweise Polyimid oder FR4, verwendet werden, auf dem LEDs 32 zusammen mit anderen elektrischen Bauelementen montiert sind. Weiterhin kann der LED-Streifen einen Lötstopplack, beispielsweise auf Acrylat- oder Epoxidharzbasis, umfassen. Der Polymer-Kleber 38 kann weiterhin auf Silikon-, PU-, oder Epoxidharzbasis sein. Der Kleber 38 wird in definierter Schichtdicke in das U-Profil hineindispensiert, anschließend wird der LED-Streifen blasenfrei ausgehärtet.

Je nach optischen Erfordernissen wird eine transparente oder weiß pigmentierte Füllschicht eingebracht. Im erfindungsgemäßen Falle der pigmentierten Schicht, also insbesondere der zweiten Grundschicht 34, endet diese bevorzugt an der LED-Oberkante, und nach dem Aushärten, z.B. thermisch, wird nochmals eine transparente Schicht, also die erste Grundschicht 22, mit definierter Höhe aufgebracht, um den Abstand zur Streuschicht 24 zu definieren. Im nicht in den Geltungsbereich der beanspruchten Erfindung fallenden Beispiel, dass die Füllschicht vollständig transparent ist, kann diese die LED-Oberkante übersteigen und gleichzeitig den Abstand der Streuschicht 24 zur LED-Oberkante definieren. Auf die noch nicht ausgehärtete transparente Schicht 22 aus Polymermatrixmaterial, z.B. Silikon oder PU, wird eine Mischung aus Polymermatrixmaterial, das insbesondere das gleiche Material ist wie die transparente Schicht 22, mit an den LED-Typ angepassten Streupartikeln dispensiert. Anschließend wird ausgehärtet, beispielsweise thermisch. Zur Befestigung des LED-Moduls 20 an einem Untergrund kann beispielsweise auf die U-Profil Rückseite ein doppelseitiges Klebeband 40 auflaminiert werden.

Mit dem schematisch dargestellten Lichtstrahl der LED 32 soll veranschaulicht werden, dass an der Grenzfläche zwischen der ersten Grundschicht 22 und der Streuschicht 24 auftretende Fresnel-Rückreflexe verhindert werden können. Insbesondere wird dies dadurch ermöglicht, dass die Streuschicht 24 auf die noch nicht ausgehärtete erste Grundschicht 22 aufdispensiert wird, woraufhin ein gemeinsames Aushärten der Schichten 22 und 24 erfolgt. Sind die Streuschicht 24 und die erste Grundschicht 22 darüber hinaus aus dem selben Material, so gibt es nach dem Aushärten dieser Schichten 22 und 24 keine Phasengrenze zwischen diesen Schichten 22 und 24, an der das Licht reflektiert wird. So kann auf besonders kostengünstige und einfach herzustellende Weise die Auskopplungseffizienz des LED-Moduls 20 erhöht werden und gleichzeitig eine besonders homogene Lichtverteilung in Bezug auf Helligkeit und Lichtfarbe ermöglicht werden. Zusätzlich können die Streu- und Transparentschichten 22 und 24 auch einen IP-Schutz darstellen.

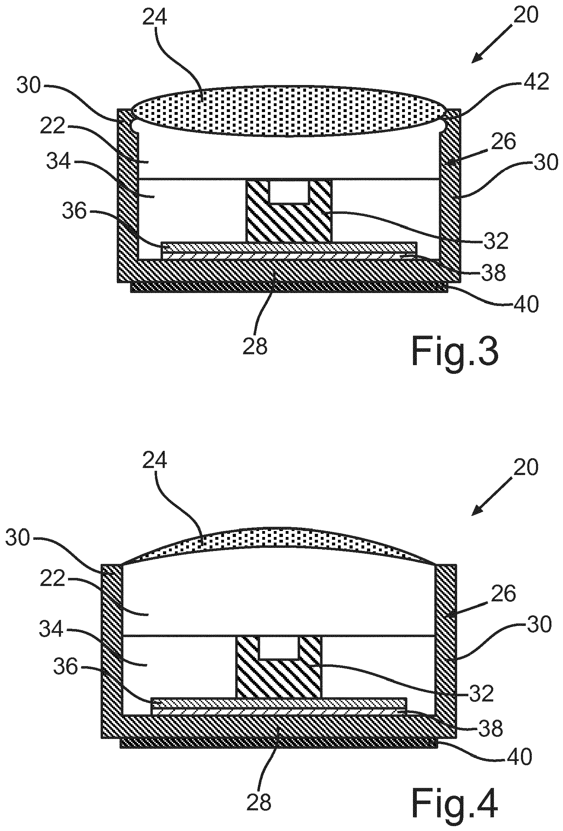

Fig. 3 zeigt eine schematische Darstellung eines LED-Moduls 20, bei dem die Streuschicht 24 als bi-konvexe Form ausgebildet ist, gemäß einem Ausführungsbeispiel der Erfindung. Dazu kann die Begrenzungsseite 30 des Gehäuses 26 eine Einkerbung 42 aufweisen. Diese Einkerbung 42 veranlasst die Transparentschicht 22 zur Formung eines Meniskus. Die Krümmung des Meniskus ist dabei abhängig von der Füllmenge des in das Gehäuse 26 eingebrachten transparenten Matrixmaterials. Auch die geometrische Form der Streuschicht 24 wird durch die Einkerbung 42 des U-Profils und die eingebrachte Materialmenge bewirkt. Die vorab dispensierte Transparentschicht 22, die einen Meniskus bildet, wird später von der Streuschicht 24 ausgefüllt, welche daraufhin eine bi-konvexe Form bildet. Dabei sollte das Polymer-Material eine gute Benetzung zum U-Profil haben und zudem eine hohe Viskosität, bevorzugt größer als 10000 mPA*s, und eine hohe Oberflächenspannung, bevorzugt größer als 50 mN/m besitzen. D.h. das Material sollte nahezu standfest sein, dabei aber immer noch leicht fließen und dabei eine glatte Oberfläche ausbilden. Beim Aushärten darf sich die Form nur noch leicht ändern, d.h. die Viskosität darf nur in geringem Maße von der Temperatur abhängen. Dieses Verhalten zeigen z.B. Silikone, andere Polymere müssen mittels der durchschnittlichen Kettenlänge entsprechen eingestellt werden.

Die Formgebung der Einkerbung 42 ist dabei nicht entscheidend, insbesondere kann die Einkerbung 42 jede beliebige Form aufweisen. Durch die Oberflächenspannung und der guten Benetzung des Materials zum U-Profil steigt das Material beim Einfüllen die Begrenzungsseite 30 hoch und bildet so einen Meniskus aus. Durch die Einkerbung 42 kann die Steighöhe an der Begrenzungsseite 30 des Gehäuses 26 begrenzt werden. Wird wenig Material eingefüllt, so ist der Meniskus stark gekrümmt, wird mehr Material eingefüllt, so ist der Meniskus weniger stark gekrümmt.

Fig. 4 zeigt eine schematische Darstellung eines LED-Moduls 20 mit einer Streuschicht 24, die eine konkav-konvexe Form aufweist, gemäß einem weiteren Ausführungsbeispiel der Erfindung. Dabei wird die Füllmenge der Transparentschicht 22 so eingestellt, dass sich eine konvexe Oberfläche ergibt. Insbesondere kann das Gehäuse 26 bis zur Lichtaustrittsseite des LED-Moduls 20 mit Material befüllt werden, d.h. bis zur Oberkante der Begrenzungsseite 30 des Gehäuses 26, so dass sich eine konvexe Form ausbildet. Dann kann auf die noch nicht ausgehärtete Transparentschicht 22 die Streuschicht 24 dispensiert werden. Auch hierbei sollte das Polymer-Material eine gute Benetzung zum U-Profil haben und zudem eine hohe Viskosität, bevorzugt größer als 10000 mPA*s, und eine hohe Oberflächenspannung, bevorzugt größer als 50 mN/m besitzen. D.h. das Material sollte auch hier nahezu standfest sein, dabei aber immer noch leicht fließen, so dass sich beim Aushärten die Form nur noch leicht ändert, d.h. die Viskosität darf nur in geringem Maße von der Temperatur abhängen.

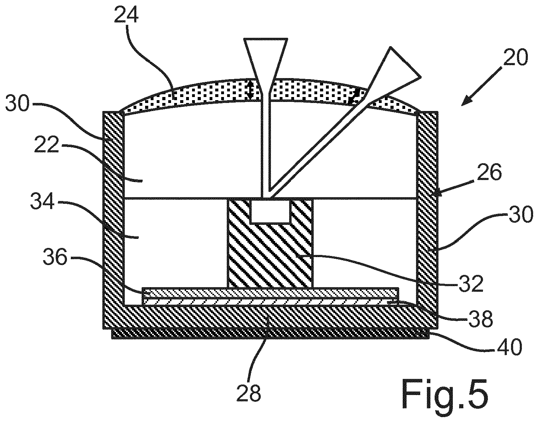

Fig. 5 zeigt eine schematische Darstellung des Lichtwegs einer LED 32 eines LED-Moduls 20 mit einer transparenten ersten Grundschicht 22 und einer Streuschicht 24 mit einer konkav-konvexen Form gemäß einem Ausführungsbeispiel der Erfindung. Durch die wie in Fig. 4 dargestellte Ausbildung der Streuschicht 24 mit einer konkav-konvexen Form kann erreicht werden, dass die makroskopische Weglänge in der Streuschicht 24 für verschiedene LED-Abstrahlwinkel in etwa gleich ist. Somit kann bewerkstelligt werden, dass von der LED 32 in unterschiedlichen Abstrahlwinkeln abgestrahltes Licht durch die Streuschicht 24 den selben Lichtmisch- und Streueffekt erfährt, wodurch ein besonders homogenes Modul-Erscheinungsbild aus verschiedenen Blickrichtungen ermöglicht wird. Dies gilt in analoger Weise auch für die in Fig. 3 dargestellte Ausgestaltungsvariante des LED-Moduls 20 mit einer bikonvex ausgebildeten Streuschicht 24. Insbesondere gilt dies für alle Ausgestaltungen mit zentral auf der Grundseite 28 des Gehäuses 26 angeordneten LEDs 32 und einer Ausbildung einer Streuschicht 24, deren Dicke von der Mitte der Abstrahlseite des LED-Moduls 20 zur Begrenzungsseite 30 des Gehäuses 26 hin abnimmt.

Insgesamt wird so ein Verfahren zum Herstellen eines LED-Moduls sowie ein LED-Modul bereitgestellt, mittels welchen die Auskopplungseffizienz und die Homogenität des abgestrahlten Lichts auf besonders vorteilhafte Weise erhöht wird. Dadurch, dass die Streuschicht in nicht ausgehärteter Form auf die noch nicht ausgehärtete Transparentschicht aufgebracht wird, das Polymermatrixmaterial der Streuschicht das gleiche ist wie das der Transparentschicht und die notwendige Streuschichtform sich an der Unterseite aus der Form der Transparentschicht, deren Krümmung durch die Füllmenge und die Ausgestaltung des U-Profils vorgegeben werden kann, ergibt, werden eine Vielzahl an Vorteilen erzielt. Es bildet sich keine Phasengrenze, wodurch ein Brechungsindexsprung zwischen Streu- und Transparentschicht vermieden wird, man erhält eine einheitliche Schicht aus Polymermatrixmaterial, da das flüssige Polymermatrixmaterial mit den Streupartikeln auf das flüssige noch nicht ausgehärtete Polymermatrixmaterial aufgetragen wird. Die Streupartikel befinden sich somit in einem definierten Abstand zur LED-Oberfläche und in einem Bereich mit definierter Form. Somit treten keine Fresnel-Rückreflexe auf, welche auf den Komponentenoberflächen absorbiert werden, es gibt keine totale interne Reflexion, welche das farblich gelblichere Licht weißer LEDs in hohen Abstrahlwinkeln zurückreflektieren und so zu einem Blau-Farbschift des Moduls führen würde. Weiterhin werden im Vergleich zu homogenen Volumenstreuern bei vergleichbarer Homogenität und Modulgeometrie wesentlich höhere Auskopplungseffizienzen erzielt. Darüber hinaus wird die geometrische Form der Streuschicht exakt durch die geometrische Ausgestaltung des U-Profils und der Füllmenge der Transparentschicht definiert. Eine Dickenreduktion der Streuschicht zum Modulrand ermöglicht ein homogeneres Erscheinungsbild des Moduls aus unterschiedlichen Blickwinkeln. Außerdem sind durch das erfindungsgemäße Herstellungsverfahren keine besonderen Oberflächenvorbehandlungen erforderlich, um eine ausreichende Haftung der Streuschicht auf der transparenten Schicht zu erzielen, und es können Farbschwankungen entlang eines linearen Moduls durch lokale Delamination mit unterschiedlichen Delaminationsabständen zwischen der Transparent- und Streuschicht vermieden werden, was sich bei anderen Produktionsverfahren nur mit sehr hohem Aufwand vermeiden lässt, z.B. durch gezielte Plasma-Oberflächenvorbehandlungen. Weiterhin gibt es keine Probleme aufgrund von Materialinkompatibilitäten der Transparent- und Streuschicht, wie Delamination, Korrosion, Degradation und Vergilbung, und die Produktion kann sehr einfach und kostengünstig mit Standard Dispens-Prozessen bewerkstelligt werden.

## Patentansprüche

1. Verfahren zum Herstellen eines LED-Moduls (20) mit den Schritten:
- Bereitstellen eines Gehäuses (26), das als Hohlkörper ausgebildet ist, der eine Öffnung an einer Lichtaustrittsseite des LED-Moduls (20) aufweist, wobei das Gehäuse (26) eine Grundseite (28) aufweist, die der Lichtaustrittsseite gegenüberliegend angeordnet ist;
- Anordnen einer Leiterplatte (36) mit mindestens einer LED (32) auf der Grundseite (28) des Gehäuses (26);
- Einfüllen einer zweiten Grundschicht (34) aus einem aushärtbaren Material in einem nicht ausgehärteten Zustand durch die Öffnung des Gehäuses (26) in das Gehäuse (26);
- Aushärten der zweiten Grundschicht (34);
- Einfüllen mindestens einer ersten Grundschicht (22) aus einem aushärtbaren Material in einem nicht ausgehärteten Zustand durch die Öffnung in das Gehäuse (26) auf die ausgehärtete zweite Grundschicht (34); und
- Einfüllen einer Streuschicht (24) aus einem aushärtbaren Material in einem nicht ausgehärteten Zustand durch die Öffnung in das Gehäuse (26);
**dadurch gekennzeichnet, dass**
die Streuschicht (24) auf die erste Grundschicht (22) eingefüllt wird, wobei die erste Grundschicht (22) beim Einfüllen der Streuschicht (24) nicht ausgehärtet ist, und nach Einfüllen der Streuschicht (24) die mindestens eine erste Grundschicht (22) und die Streuschicht (24) ausgehärtet werden,
wobei die zweite Grundschicht (34) eine weiße Pigmentierung aufweist und die weiße Pigmentierung dazu eingerichtet ist, zurückreflektiertes Licht zu reflektieren,
wobei die LED (32) eine Lichtaustrittsseite aufweist, die eine Oberkante der LED (32) definiert und die mindestens eine erste Grundschicht (22) derart eingefüllt wird,
dass nach dem Einfüllen eine der zweiten Grundschicht (34) abgewandte Oberfläche der ersten Grundschicht (22) einen Abstand zur Lichtaustrittsseite des LED-Moduls (20) aufweist, der kleiner ist als ein Abstand der Oberkante der LED (32) von der Lichtaustrittsseite des LED-Moduls (20) und wobei die zweite Grundschicht (34) höchstens bis zur Oberkante der LED (32) eingefüllt wird.

2. Verfahren zum Herstellen eines LED-Moduls (20) mit den Schritten:
- Bereitstellen eines Gehäuses (26), das als Hohlkörper ausgebildet ist, der eine Öffnung an einer Lichtaustrittsseite des LED-Moduls (20) aufweist, wobei das Gehäuse (26) eine Grundseite (28) aufweist, die der Lichtaustrittsseite gegenüberliegend angeordnet ist;
- Anordnen einer Leiterplatte (36) mit mindestens einer LED (32) auf der Grundseite (28) des Gehäuses (26);
- Einfüllen einer zweiten Grundschicht (34) aus einem aushärtbaren Material in einem nicht ausgehärteten Zustand durch die Öffnung des Gehäuses (26) in das Gehäuse (26);
- Aushärten der zweiten Grundschicht (34);
- Einfüllen mindestens einer ersten Grundschicht (22) aus einem aushärtbaren Material in einem nicht ausgehärteten Zustand durch die Öffnung in das Gehäuse (26) auf die ausgehärtete zweite Grundschicht (34); und
- Einfüllen einer Streuschicht (24) aus einem aushärtbaren Material in einem nicht ausgehärteten Zustand;
**dadurch gekennzeichnet, dass**
die Streuschicht (24) auf die erste Grundschicht (22) eingefüllt wird, wobei die erste Grundschicht (22) beim Einfüllen der Streuschicht (24) nicht ausgehärtet ist, und nach Einfüllen der Streuschicht (24) die mindestens eine erste Grundschicht (22) und die Streuschicht (24) ausgehärtet werden,
wobei
beim Einfüllen der ersten Grundschicht (22) bis an den oberen Rand des Gehäuses (26) derart viel aushärtbares Material eingefüllt wird, dass sich eine nach außen wölbende konvexe Oberfläche der eingefüllten Grundschicht (22) ausbildet,
wobei die zweite Grundschicht (34) eine weiße Pigmentierung aufweist und die weiße Pigmentierung dazu eingerichtet ist, zurückreflektiertes Licht zu reflektieren und
wobei die zweite Grundschicht (34) höchstens bis zur Oberkante der LED (32) eingefüllt wird.

3. Verfahren nach Anspruch 1,
**dadurch gekennzeichnet, dass**
beim Bereitstellen des Gehäuses (26) in eine Begrenzungsseite (30) des Gehäuses (26), die an der Grundseite (28) angeordnet ist und sich von der Grundseite (28) bis zur Lichtaustrittsseite des LED-Moduls (20) erstreckt, wobei die Grundseite (28) und die Begrenzungsseite (30) den Hohlkörper mit der Öffnung definieren, zumindest bereichsweise eine Einkerbung (42), in die dem Hohlkörper zugewandte Oberfläche der Begrenzungsseite (30) -eingebracht wird, wobei diese Einkerbung (42) in einem Abstand zur Grundseite (28) des Gehäuses (26) verläuft, wobei beim Einfüllen der ersten Grundschicht (22) derart viel aushärtbares Material eingefüllt wird, dass die Begrenzungsseite (30) maximal bis zur Einkerbung (42) mit der Grundschicht (22) benetzt wird und sich eine nach innen wölbende konkave Oberfläche der eingefüllten Grundschicht (22) ausbildet.

4. Verfahren nach einem der vorhergehenden Ansprüche, **dadurch gekennzeichnet, dass**
für die Streuschicht (24) ein Material verwendet wird, das ein Basismaterial mit Streupartikeln umfasst, wobei das Basismaterial dasselbe Material ist, wie das der ersten Grundschicht (22), so dass sich beim Aushärten der ersten Grundschicht (22) und der Streuschicht (24) keine Phasengrenze bildet.

5. Verfahren nach einem der Ansprüche 2 bis 4,
**dadurch gekennzeichnet, dass**
die Streuschicht (24) derart ausgebildet wird, dass deren Dicke von der Mitte der Abstrahlseite des LED-Moduls (20) zur Begrenzungsseite (30) des Gehäuses (26) hin abnimmt.

6. Verfahren nach einem der vorhergehenden Ansprüche,
**dadurch gekennzeichnet, dass**
eine Vielzahl von LEDs (32) linear auf der Leiterplatte angeordnet ist.

7. LED-Modul (20), aufweisend
- ein Gehäuse (26), das als Hohlkörper ausgebildet ist, der eine Öffnung an einer Lichtaustrittsseite des LED-Moduls (20) aufweist, wobei das Gehäuse (26) eine Grundseite (28) aufweist, die der Lichtaustrittsseite gegenüberliegend angeordnet ist;
- eine Leiterplatte (36) mit mindestens einer LED (32), wobei die Leiterplatte (36) auf der Grundseite (28) des Gehäuses (26) angeordnet ist;
- eine zweite Grundschicht (34) aus einem ausgehärteten Material;
- eine ersten Grundschicht (22) aus einem ausgehärteten Material
- eine Streuschicht (24) aus einem ausgehärteten Material;
**dadurch gekennzeichnet, dass**
das LED Modul (20) nach einem der vorhergehenden Ansprüche hergestellt worden ist.

8. LED-Modul (20) gemäß Anspruch 7,
**dadurch gekennzeichnet, dass**
das LED-Modul (20) als lineares Modul ausgebildet ist.

## Claims

1. Method of manufacturing an LED module (20), comprising the steps:
- providing a housing (26), which is formed as a hollow body which has an opening on a light exit side of the LED module (20), wherein the housing (26) has a base side (28), which is arranged opposite the light exit side;
- arranging a circuit board (36) having at least one LED (32) on the base side (28) of the housing (26);
- pouring a second base layer (34) made of a curable material in a non-cured state into the housing (26) through the opening of the housing (26);
- curing the second base layer (34);
- pouring at least one first base layer (22) made of a curable material in a non-cured state onto the cured second base layer (34) through the opening in the housing (26); and
- pouring a scattering layer (24) made of a curable material in a non-cured state into the housing (26) through the opening;
**characterized in that**
the scattering layer (24) is poured onto the first base layer (22), wherein the first base layer (22) is not cured when the scattering layer (24) is poured in and, after the scattering layer (24) has been poured in, the at least one first base layer (22) and the scattering layer (24) are cured,
wherein the second base layer (34) has a white pigmentation and the white pigmentation is set up to reflect back-reflected light,
wherein the LED (32) has a light exit side which defines an upper edge of the LED (32), and the at least one first base layer (22) is poured in in such a way that, following the pouring-in, a surface of the first base layer (22) that faces away from the second base layer (34) has a distance from the light exit side of the LED module (20) which is smaller than a distance of the upper edge of the LED (32) from the light exit side of the LED module (20),
and
wherein the second base layer (34) is poured in at most as far as the upper edge of the LED (32).

2. Method of manufacturing an LED module (20) comprising the steps:
- providing a housing (26), which is formed as a hollow body which has an opening on a light exit side of the LED module (20), wherein the housing (26) has a base side (28), which is arranged opposite the light exit side;
- arranging a circuit board (36) having at least one LED (32) on the base side (28) of the housing (26);
- pouring a second base layer (34) made of a curable material in a non-cured state into the housing (26) through the opening of the housing (26);
- curing the second base layer (34);
- pouring at least one first base layer (22) made of a curable material in a non-cured state onto the cured second base layer (34) through the opening in the housing (26); and
- pouring a scattering layer (24) made of a curable material in a non-cured state;
**characterized in that**
the scattering layer (24) is poured onto the first base layer (22), wherein the first base layer (22) is not cured when the scattering layer (24) is poured in and, after the scattering layer (24) has been poured in, the at least one first base layer (22) and the scattering layer (24) are cured,
wherein
when pouring the first base layer (22) in as far as the upper edge of the housing (26), a sufficient amount of curable material is poured, **in that** an outwardly curved convex surface of the base layer (22) poured in is formed, wherein the second base layer (34) has a white pigmentation and the white pigmentation is set up to reflect back-reflected light, and
wherein the second base layer (34) is poured in at most as far as the upper edge of the LED (32).

3. Method according to Claim 1,
**characterized in that**
during the provision of the housing (26), a notch (42) is introduced, in at least some regions of that surface of the delimitation side (30) which faces the hollow body, into a delimitation side (30) of the housing (26) which is arranged on the base side (28) and extends from the base side (28) as far as the light exit side of the LED module (20), wherein the base side (28) and the delimitation side (30) define the hollow body having the opening, wherein this notch (42) extends at a distance from the base side (28) of the housing (26), wherein, as the first base layer (22) is poured in, a sufficient amount of curable material is poured, **in that** the delimitation side (30) is wetted with the base layer (22) at most as far as the notch (42) and an inwardly curved concave surface of the base layer (22) poured in is formed.

4. Method according to one of the preceding claims,
**characterized in that**
a material is used for the scattering layer (24) which comprises a base material having scattering particles,
wherein the base material is the same material as that of the first base layer (22), so that when the first base layer (22) and the scattering layer (24) are cured, no phase boundary is formed.

5. Method according to one of Claims 2 to 4,
**characterized in that**
the scattering layer (24) is formed in such a way that its thickness decreases from the centre of the emission side of the LED module (20) toward the delimitation side (30) of the housing (26).

6. Method according to one of the preceding claims,
**characterized in that**
a plurality of LEDs (32) is arranged linearly on the circuit board.

7. LED module (20), having
- a housing (26), which is formed as a hollow body which has an opening on a light exit side of the LED module (20), wherein the housing (26) has a base side (28) which is arranged opposite the light exit side;
- a circuit board (36) having at least one LED (32), wherein the circuit board (36) is arranged on the base side (28) of the housing (26);
- a second base layer (34) made of a curable material;
- a first base layer (22) made of a curable material;
- a scattering layer (24) made of a curable material;
**characterized in that**
the LED module (20) has been manufactured according to one of the preceding claims.

8. LED module (20) according to Claim 7,
**characterized in that**
the LED module (20) is formed as a linear module.

## Revendications

1. Procédé de fabrication d'un module DEL (20), comprenant les étapes suivantes :
- mise à disposition d'un boîtier (26) conçu sous forme de corps creux comportant une ouverture sur un côté de sortie de lumière du module DEL (20), le boîtier (26) comportant un côté formant base (28) disposé en vis-à-vis du côté de sortie de lumière ;
- agencement d'une carte à circuits imprimés (36) comportant au moins une DEL (32) sur le côté formant base (28) du boîtier (26) ;
- versement dans le boîtier (26) d'une deuxième couche de base (34) en un matériau durcissable en état non durci à travers l'ouverture du boîtier (26) ;
- durcissement de la deuxième couche de base (34) ;
- versement d'au moins une première couche de base (22) en un matériau durcissable en état non durci à travers l'ouverture du boîtier (26) sur la deuxième couche de base (34) durcie ; et
- versement dans le boîtier (26) d'une couche diffusante (24) en un matériau durcissable en état non durci à travers l'ouverture ;
**caractérisé en ce que**
la couche diffusante (24) est versée sur la première couche de base (22), la première couche de base (22) n'étant pas durcie lors du versement de la couche diffusante (24), et après versement de la couche diffusante (24),
l'au moins une première couche de base (22) et la couche diffusante (24) étant durcies, la deuxième couche de base (34) présentant une pigmentation blanche, la pigmentation blanche étant conçue pour refléter de la lumière réfléchie, la DEL (32) présentant un côté de sortie de lumière définissant un bord supérieur de la DEL (32) et l'au moins une première couche de base (22) étant versée de manière qu'après le versement, une surface de la première couche de base (22) détournée de la deuxième couche de base (34) présente une distance par rapport au côté de sortie de lumière du module DEL (20) qui est inférieure à une distance du bord supérieur de la DEL (32) du côté de sortie de lumière du module DEL (20), la deuxième couche de base (34) n'étant versée que jusqu'au bord supérieur de la DEL (32) au maximum.

2. Procédé de fabrication d'un module DEL (20), comprenant les étapes suivantes :
- mise à disposition d'un boîtier (26) conçu sous forme de corps creux comportant une ouverture sur un côté de sortie de lumière du module DEL (20), le boîtier (26) comportant un côté formant base (28) disposé en vis-à-vis du côté de sortie de lumière ;
- agencement d'une carte à circuits imprimés (36) comportant au moins une DEL (32) sur le côté formant base (28) du boîtier (26) ;
- versement dans le boîtier (26) d'une deuxième couche de base (34) en un matériau durcissable en état non durci à travers l'ouverture du boîtier (26) ;
- durcissement de la deuxième couche de base (34) ;
- versement d'au moins une première couche de base (22) en un matériau durcissable en état non durci à travers l'ouverture du boîtier (26) sur la deuxième couche de base (34) durcie ; et
- versement d'une couche diffusante (24) en un matériau durcissable en état non durci ;
**caractérisé en ce que**
la couche diffusante (24) est versée sur la première couche de base (22), la première couche de base (22) n'étant pas durcie lors du versement de la couche diffusante (24) et qu'après versement de la couche diffusante (24), l'au moins une couche de base (22) et la couche diffusante (24) sont durcies, le versement de la première couche de base (22) jusqu'au bord supérieur du boitier (26) se faisant de manière qu'il y a versement d'autant de matériau durcissable que la couche de base (22) versée forme une surface convexe se voûtant vers l'extérieur, la deuxième couche de base (34) présentant une pigmentation blanche et la pigmentation blanche étant conçue pour refléter de la lumière réfléchie, le niveau de remplissage maximum de la deuxième couche de base (34) étant le bord supérieur de la DEL (32).

3. Procédé selon la revendication 1,
**caractérisé en ce que**,
lors de la mise à disposition du boîtier (26), dans un côté de délimitation (30) du boîtier (26) disposé sur le côté formant base (28) et s'étendant depuis le côté formant base (28) jusqu'au côté de sortie de lumière du module DEL (20), le côté formant base (28) et le côté de délimitation (30) définissant le corps creux comportant l'ouverture, une encoche (42) est ménagée au moins par sections dans la surface du côté de délimitation (30) en regard du corps creux, ladite encoche (42) s'étendant dans une distance par rapport au côté formant base (28) du boîtier (26), le versement de la première couche de base (22) comportant le versement d'autant de matériau durcissable que le côté de délimitation (30) est humecté au maximum jusqu'à l'encoche (42) par la couche de base (22) et la formation d'une surface concave incurvée vers l'intérieur de la couche de base (22).

4. Procédé selon l'une des revendication précédentes,
**caractérisé en ce que**
pour la couche diffusante (24), on utilise un matériau comportant un matériau de base incluant des particules diffusantes, le matériau de base étant le même matériau que celui de la première couche de base (22), de manière que lors du durcissement de la première couche de base (22) et de la couche diffusante (24), il n'y a pas formation de limite de phase.

5. Procédé selon l'une des revendications 2 à 4,
**caractérisé en ce que**
la couche diffusante (24) est conçue de manière que son épaisseur décroît depuis le centre du côté d'émission du module DEL (20) vers le côté de délimitation (30) du boîtier (26).

6. Procédé selon l'une des revendication précédentes,
**caractérisé en ce qu'**
une multitude de diodes électroluminescentes (32) est disposée de façon linéaire sur la carte à circuits imprimés.

7. Module DEL (20), comportant
- un boîtier (26) conçu sous forme de corps creux comportant une ouverture sur un côté de sortie de lumière du module DEL (20), le boîtier (26) comportant un côté formant base (28) disposé en vis-à-vis du côté de sortie de lumière ;
- une carte à circuits imprimés (36) comportant au moins une DEL (32), la carte à circuits imprimés (36) étant disposée sur le côté formant base (28) du boîtier (26) ;
- une deuxième couche de base (34) en un matériau durci ;
- une première couche de base (22) en un matériau durci ;
- une couche diffusante (24) en un matériau durci ;
**caractérisé en ce que**
le module DEL (20) a été fabriqué selon l'une des revendications précédentes.

8. Module DEL (20) selon la revendication 7,
**caractérisé en ce que**
le module DEL (20) est conçu sous forme de module linéaire.
